# EUROPÄISCHE PATENTSCHRIFT

(11) **EP 1 297 384 B1**
(45) Veröffentlichungstag und Bekanntmachung des Hinweises auf die Patenterteilung: **02.11.2006**
(21) Anmeldenummer: 01940050.6
(22) Anmeldetag: 26.06.2001
(51) Int. Cl.: G03F 1/00, H01L 21/00

(54) **VORRICHTUNG UND VERFAHREN ZUR REINIGUNG VON IN DER PRODUKTION VON HALBLEITERELEMENTEN BENUTZTEN OBJEKTEN**
DEVICE AND METHOD FOR CLEANING ARTICLES USED IN THE PRODUCTION OF SEMICONDUCTOR COMPONENTS
DISPOSITIF ET PROCEDE POUR NETTOYER DES OBJETS UTILISES DANS LA PRODUCTION D'ELEMENTS A SEMI-CONDUCTEUR

(30) Priorität: 27.06.2000 CH 127000
(43) Veröffentlichungstag der Anmeldung: 02.04.2003
(73) Patentinhaber: Brooks-PRI Automation (Switzerland) GmbH, 8274 Tägerwilen (CH)
(72) Erfinder: BLATTNER, Jakob, CH-8272 Ermatingen (CH); RUDY, Federici, CH-8572 Berg (CH)
(74) Vertreter: EGLI-EUROPEAN PATENT ATTORNEYS
(86) Internationale Anmeldenummer: PCT/CH2001/000402
(87) Internationale Veröffentlichungsnummer: WO 2002/001292

(56) Entgegenhaltungen:
- DE-A- 3 820 931
- DE-A- 4 237 767
- US-A- 5 916 374
- US-A- 6 055 742

## Beschreibung

Die Erfindung betrifft eine Reinigungsvorrichtung und ein Reinigungsverfahren für die Produktion von Halbleiterelementen, wie elektronischen Chips, Speicherelementen und dergleichen, gemäss den Oberbegriffen der Ansprüche 1, 10 und 14. Gemäss einem weiteren Aspekt betrifft die Erfindung auch eine Vorrichtung zur Lagerung von Objekten aus der Halbleiterproduktion, wie sie im Oberbegriff von Anspruch 11 beschrieben ist.

Bei der Herstellung von elektronischen Bauteilen, wie beispielsweise Chips oder Speicherbausteinen werden Belichtungsmasken (auch Recticle genannt) verwendet, mit denen durch licht-chemische Verfahren auf Substraten der Bauteile bestimmte Strukturen erzeugt werden. Da diese Strukturen Leiterbahnen im Mikrometer- oder sogar Nano-Bereich aufweisen und selbst kleinste Verunreinigungen des Substrats und/oder der Belichtungsmaske zu Ausschuss, d.h. nicht den Qualitätsanforderungen entsprechenden Produkten, führt, wird höchste Sauberkeit gefordert. Deshalb findet die Produktion solcher Bauteile unter Rein- bzw. Reinstraumbedingungen statt. Um die Belichtungsmasken vor mechanischer Beschädigung und vor Verschmutzungen zu schützen, werden diese in Kassetten oder in luftdicht abgeschlossenen Magazinen aufbewahrt und gehandhabt.

Grössere Partikel können ohne weiteres erkannt und entfernt werden. Problematisch sind kleinere Partikel, beispielsweise mit Dimensionen von 10 µm bis 20µm, die bislang nur mit sehr grossem Aufwand entfernt werden konnten. Hierzu wurden Reinigungsverfahren entwickelt, bei denen mit einer Flüssigkeit die Halbleiterproduktionsmittel oder die entsprechenden Bauteile bzw. deren Ausgangsprodukte gewaschen wurden. Diese Reinigungsverfahren bedingen zum einen relativ grossen konstruktiven Aufwand bezüglich der hierzu erforderlichen Geräte. Zum anderen müssen die verwendeten Waschflüssigkeiten aufbereitet oder durch frische Flüssigkeiten ersetzt werden. Weiter kann nicht zufriedenstellen, dass die gereinigten Objekte unmittelbar nach dem Prozess feucht sind und deshalb trocknen müssen, bis sie weiterverwendet bzw. verarbeitet werden können.

Es hat sich jedoch gezeigt, dass trotz diesen Massnahmen eine Verschmutzung der Belichtungsmasken nicht ausreichend vermieden werden kann. Vorbekannte Reinigungsvorrichtungen haben zudem den Nachteil, dass sie in den Halbleiterfabriken eine vergleichsweise grosse Stellfläche (Footprint) benötigen. Dies ist insbesondere deshalb nachteilig, weil in den Fabriken teuere Anlagen zur Erzeugung von Reinraumbedingungen installiert werden müssen, deren Kosten mit der Grösse der Fabrik proportional steigen.

Aus der US-A-5 967 156 ist eine Oberflächenbehandlungvorrichtung bekannt, bei der aus zwei Düsen unterschiedliche Reinigungsmittel, nämlich ein Aerosol und ein anderes Reagenz, auf eine einzige Oberfläche eines Substrates gebracht werden, was aus verfahrenstechnischer Sicht nachteilig ist. Das Reagenz wird nach der US-A-5 967 156 entfernt vom Reinigungspunkt abgesaugt, ohne irgendeine Geometrie des Absaugvorganges auszunutzen.

Aus der US-A-5 857 474 ist eine Vorrichtung und ein entsprechendes Verfahren zum Waschen einer Oberfläche eines Halbleiterproduktes mit gefrorenem Wasser, das aus einer Wasserversorgungsdüse zugeleitet wird und einer Gaszuführung zum Wegblasen der entstandenen Eispartikel von der Oberfläche des Halbleiterproduktes bekannt, das die aufgezeigten Nachteile vereint.

Aus der US-A-6 055 742 ist eine Recticlereinigungsvorrichtung bekannt, bei der eine Gaszuführungseinrichtung im oberen Bereich einer Reinigungskammer sowie eine Türeinrichtung und eine Transporteinrichtung zum Zuführen des Recticles vorgesehen ist. Da mit einer solchen Vorrichtung - konstruktionsgemäss wegen der Befestigung der Recticles in der Reinigungskammer - nur eine Seite eines Recticles gereinigt werden kann, ergibt sich der Nachteil einer grossen Stellfläche, wenn eine zweite Reinigungsvorrichtung für die zweite Seite vorgesehen werden soll. Nicht über den diesbezüglichen Offenbarungsgehalt hinaus geht auch die Offenbarung einer aus der JP-A-03 155 550 bekannten Vorrichtung, bei der eine Oberfläche eines Halbleiterproduktes dadurch inspiziert wird, dass Fremdkörper abgeblasen werden und dann der Effekt beobachtet wird.

Aus der JP-A-04 151 153 ist eine Vorrichtung und ein entsprechendes verfahren bekannt, bei der in einer Scanning-Betriebsart ein komprimiertes Gas auf eine Oberfläche eines zu prüfenden Halbleiterproduktes geleitet wird, um zwischen Defekten im Halbleiterprodukt und verunreinigenden Partikeln auf demselben funktional zu unterscheiden.

Aus der JP-A-61 087326 ist ein Verfahren zum Reinigen von Röntgenstrahlungsmasken offenbart, bei dem ein zugeführtes Sauerstoffgas durch ein Plasma in atomaren Sauerstoff verwandelt wird, und so organische Verunreinigungen auf der Oberfläche der Röntgenstrahlungsmasken gereinigt werden.

Aus der US-A-4 677 704 ist ein Reinigungssystem für ein statisch aufgeladene Oberfläche eines Halbleiterwafers bekannt, bei ein Gas, an dem Vibrationen erzeugt wurden, auf eine Oberfläche eines Wafers geleitet werden, wobei die statische Aufladung auf ein Minimum gehalten wird. Aus der JP-A-55 134 851 ist eine Maskenreinigungsvorrichtung bekannt, bei der ein mit Ozon gemischtes Gas rechtwinklig auf eine Oberfläche einer in einem Trockenplattenhalter gehaltenen Trockenplatte geblasen wird, um so Staub von der Platte zu blasen, wobei das Schmutz enthaltende Gas dann durch Auslässe der Reinigungsvorrichtung abgesaugt wird.

Aus der JP-A-06 168 864 ist eine Reinigungsvorrichtung bekannt, bei der Stickstoff mit Hilfe einer Gasdusche auf eine Oberfläche eines Recticles geblasen wird, wobei Staub von der Oberfläche entfernt und diese gleichzeitig durch das Stickstoffgas entladen wird.

Aus der US-A-4 715 392 ist eine Wasch- und Reinigungseinrichtung für Halbleiterprodukte bekannt, bei der Fremdpartikel mit einer Reinigungsflüssigkeit von der zu säubernden Oberfläche des Halbleiterproduktes gewaschen werden, wonach das Halbleiterprodukt einer Inspektionseinrichtung für Fremdpartikel zugeführt wird und dann gegebenenfalls in die eine Wasch- und Reinigungseinrichtung zurück befördert wird.

Hier setzt die Erfindung ein, der die Aufgabe zugrunde liegt, Massnahmen anzugeben, mit denen sich bei möglichst wenig Aufwand bei der Herstellung von Halbleiterbauelementen der Ausschuss reduzieren lässt, der aufgrund von Verunreinigungen entsteht. Gemäss einem Aspekt der Erfindung soll mit erfindungsgemässen Vorrichtungen möglichst wenig Stellfläche benötigt werden und die Reinigung effizient durchgeführt werden können.

Es wird deshalb eine erfindungsgemässe Reinigungsvorrichtung für die Halbleiterproduktion vorgeschlagen, die mit zwei Zuführeinrichtungen versehen ist, mit denen jeweils ein fluides Medium über jeweils eine Oberfläche eines zu reinigenden Objekts, insbesondere eines Halbleiterproduktionsmittels, führbar ist, so dass sich unterschiedliche Seiten des Objektes gleichzeitig reinigen lassen, wobei in eine Reinigungskammer zumindest zwei Gaszuführeinrichtungen zur Einführung eines unter Überdruck stehenden Reinigungsgases münden, die Gaszuführeinrichtungen jeweils ein Mittel zur Richtung eines Gasstromes auf eine Oberfläche des zu reinigenden Objekts aufweisen, aus der Reinigungskammer zumindest zwei Absaugmittel herausführen, mit der in die Reinigungskammer hineingeleitetes Gas abführbar ist, und ein Träger zur Halterung des Objektes in der Reinigungskammer vorhanden ist, wobei das Objekt in die Reinigungskammer durch zumindest einen Spalt in der Reinigungskammer einführbar ist sowie in der Reinigungskammer befindliches Gas und Partikel mit zumindest zwei Ionisationsmittel ionisierbar ist, wobei sich jeweils ein Ionisationsmittel zwischen jeweils einem Richtungsmittel und einer Absaugeinrichtung befindet.

Die Massnahmen der Erfindung haben zunächst einmal zur Folge, dass ein - vorzugsweise flaches - Objekt der Halbleiterproduktion gleichzeitig von zwei Seiten mit einem platz- und resourcensparend gereinigt werden kann.

Die Aufgabe wird auch durch das Verfahren gemäss Anspruch 14 gelöst, bei dem das zu reinigende Objekt in eine solche Reinigungskammer eingeführt wird, ein gasförmiges Medium - vorzugsweise unter einem Winkel von kleiner 90° - auf eine Oberfläche des zu reinigenden Objektes geleitet wird und von der Oberfläche des Objektes abgelenktes gasförmiges Medium abgesaugt wird.

Anders als vorbekannte Reinigungsvorrichtungen und -verfahren aus der Halbleiterproduktion wird erfindungsgemäss mit einem gasförmigen - und damit mit einem trockenen - Fluid gereinigt. Es hat sich überraschenderweise gezeigt, dass sich auch mit Gasen Verschmutzungspartikel mit grosser Zuverlässigkeit entfernen lassen. Mit der erfindungsgemässen Reinigungsvorrichtung können vorzugsweise Halbleiterproduktionsmittel, insbesondere sogenannte Reticles, gereinigt werden. Selbstverständlich ist es aber auch möglich damit Halbleiterprodukte bzw. Zwischenprodukte wie Wafer zu reinigen.

Hierbei ist bevorzugt, wenn in dem gleichen Gehäuse wie die Reinigungsvorrichtung auch eine Detektionseinrichtung zur Detektion von auf den zu reinigenden Objekten abgelagerten Verschmutzungen untergebracht ist. Die insgesamt benötigte Stellfläche für die beiden Funktionseinheiten kann verringert werden, da diese auf gemeinsame Komponenten wie eine Einrichtung zur Aufbereitung von Reinluft, eine gemeinsame elektrische Versorgungseinrichtung und Rechnereinrichtung zur Steuerung der Funktionseinheiten, eine Handhabungseinrichtung, etc. zugreifen können. Die benötigte Stellfläche wird besonders klein, wenn einzelne Funktionseinheiten der Vorrichtung im Wesentlichen übereinander angeordnet sind.

Gemäss einem weiteren erfindungsgemässen Aspekt ist in einem Stocker (Lagereinrichtung) für Objekte aus der Halbleiterproduktion, insbesondere Reticles, eine Reinigungsvorrichtung integriert, mit der die Objekte gereinigt werden können. Mit einer derartigen kombinierten Reinigungs- und Lagervorrichtung kann zum einen ebenfalls die in einer Halbleiterfabrik erforderliche Stellfläche reduziert werden, da auch hier einzelne Funktionseinheiten in einem gemeinsamen Gehäuse integriert sind. Zum anderen können auch diese Funktionseinheiten gemeinsame Komponente nutzen. Beispielhaft hierfür sind wiederum eine Anlage zur Erzeugung von Reinraumbedingungen innerhalb des Gehäuses, eine gemeinsame Handhabungseinrichtung, mit der die Halbleiterproduktionsmittel den einzelnen Funktionseinheiten zugeführt und von ihnen entnommen werden oder ein gemeinsamer Steuerrechner. Der Steuerrechner übernimmt vorteilhafterweise sowohl Steuer- und Verwaltungsfunktionen, die die einzelnen Funktionseinheiten selbst betreffen, als auch Steuerfunktionen bezüglich der Koordination von Abläufen zwischen den Funktionseinheiten. Der Steuerrechner sollte insbesondere die Verwaltung der in der Lagereinrichtung zwischengelagerten Objekten übernehmen und Informationen über sie abspeichern.

Aufgrund der Vorteile der oben beschriebenen erfindungsgemässen Reinigungsvorrichtungen ist es zweckdienlich eine solche auch in einer erfindungsgemässen kombinierten Reinigungs- und Lagervorrichtung vorzusehen.

In einer bevorzugten Weiterbildung der erfindungsgemässen Lagereinrichtung kann zusätzlich auch eine Detektionseinrichtung in das Gehäuse integriert sein, mit der auf einer Oberfläche eines Halbleiterproduktionsmittels vorhandene Verschmutzungen detektiert werden können. Beispielsweise um Reticles zu überprüfen, kann eine von der Anmelderin unter der Bezeichnung "Particle Detection System (PDS)" angebotene - und damit vorbekannte - Detektionseinrichtung zum Einsatz kommen. Diese weist als Lichtemissionselement einen Laser auf. Die mit ihm erzeugten zwei Laserstrahlen werden im Wesentlichen parallel über die Ober- (Glasseite des Reticles) und Unterseite (sogenannte Pellicle-Seite) der Reticles geführt. Befinden sich Schmutzpartikel auf einer der Seiten, so wird an dieser Stelle der Laserstrahl abgelenkt. Das Reticle wird mit seiner Ober- und Unterseite mit Abstand an jeweils einer Kamera vorbeigeführt, mit der abgelenktes Licht gemessen wird. Die Grösse und Position von einzelnen Partikeln kann aufgrund der Intensität des abgelenkten Lichts bestimmt werden.

Weitere bevorzugte Ausgestaltungen der Erfindung ergeben sich aus den abhängigen Ansprüchen, der Zeichnung und der dazugehörenden Beschreibung.

Die Erfindung wird anhand den in den Figuren schematisch dargestellten Ausführungsbeispielen näher erläutert; es zeigen:
- Fig. 1: eine erfindungsgemässe Lagervorrichtung in einer Seitenansicht, bei der mehrere Funktionseinheiten in einem Gehäuse integriert sind;
- Fig. 2: ein SMIF-Behälter mit darin angeordneten Reticles;
- Fig. 3: eine Detektionseinrichtung in einer stark schematisierten Darstellung;
- Fig. 4: ein Ausführungsbeispiel einer erfindungsgemässen Reinigunsvorrichtung;
- Fig. 5: ein Greifer einer Handhabungseinrichtung der erfindungsgemässen Vorrichtung;
- Fig. 6: die Lagervorrichtung aus Fig. 1 in einer ver einfachten Darstellung einer weiteren Seiten ansicht.

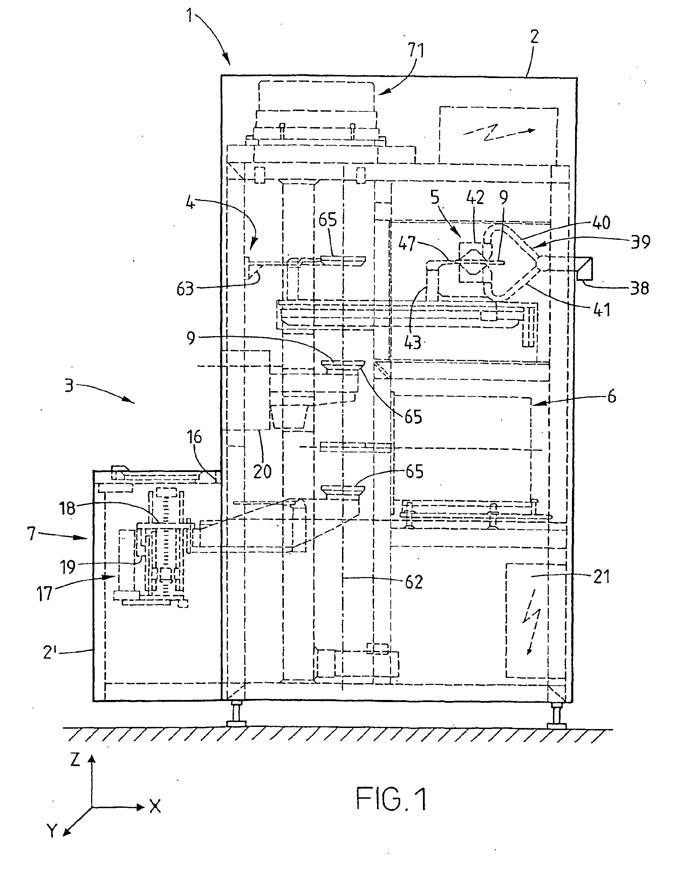

In Fig. 1 ist eine erfindungsgemässe Reinigungs- und Lagervorrichtung 1 für Reticles gezeigt, die ein im Querschnitt im Wesentlichen rechteckförmiges Gehäuse 2 aufweist, durch das die Vorrichtung 1 allseitig geschlossen ist. In dem Gehäuse 2 sind mehrere Funktionseinheiten untergebracht, die im Zusammenhang mit den Reticles unterschiedliche Funktionen ausführen. Hierbei handelt es sich um eine Ein-/Ausgabeeinrichtung 3, eine Handhabungseinrichtung 4, eine Reinigungseinrichtung 5 und eine Detektionseinrichtung 6.

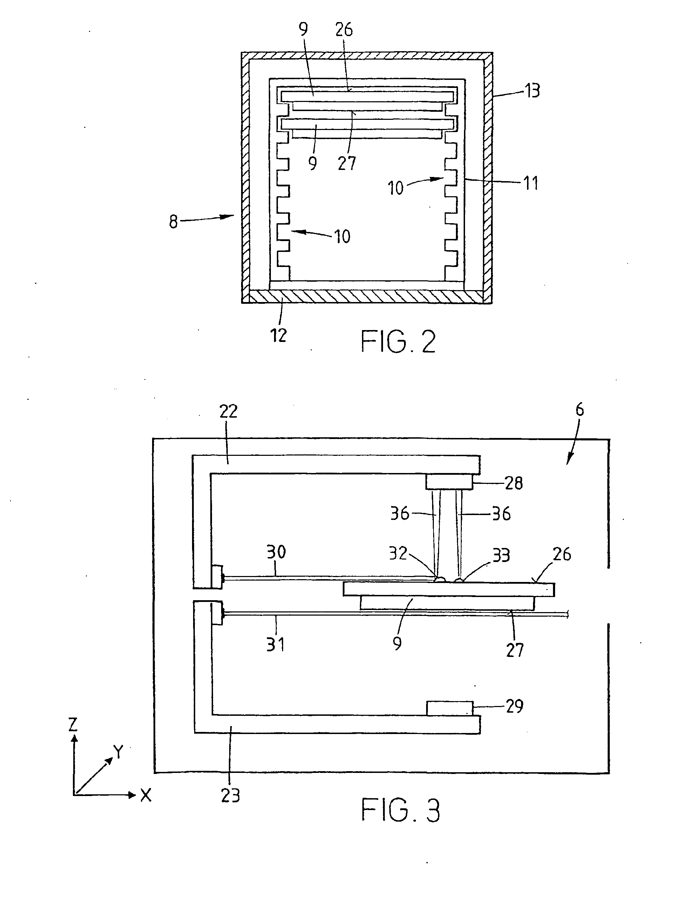

Die Ein-/Ausgabeeinrichtung 3 weist an einer Seite des Gehäuses 2 zum einen eine sogenannte SMIF-Station 7 auf, mit der an sich vorbekannte Transportbehälter (nicht dargestellt) geöffnet und darin angeordnete Reticles entnommen werden können. Der Begriff SMIF ist eine Abkürzung für "Standard Mechanical Interface" und bezeichnet die in der Halbleiterbranche üblichen standardisierten Transportbehälter. In Fig. 2 ist rein schematisch ein solcher Behälter 8 gezeigt, bei dem die Reticles 9 in Fächern 10 eines Magazin 11 des Behälters 8 angeordnet sind. Das Magazin 11 steht auf einer Bodenplatte 12 des Behälters, die mit einer Behälterhaube 13 luftdicht verschliessbar ist, so dass in diesem Zustand die Reticles 9 nicht der Umgebungsatmosphäre ausgesetzt sind.

Die in Fig. 1 gezeigte SMIF-Station 7 kann prinzipiell gleich aufgebaut sein, wie die in der europäischen Patentanmeldung EP 0 875 921 der gleichen Anmelderin beschriebene Station der gleichen Anmelderin. Zwar betrifft die in der genannten europäischen Patentanmeldung beschriebene SMIF-Station eine Vorrichtung zur Handhabung von SMIF-Behältern für Wafer. Um anstelle von Wafern Kassetten für Reticles zu handhaben, sind jedoch nur geringfügige Anpassungen erforderlich.

Die SMIF-Station 7 ist von einem bodennahen Teil 2' des Gehäuses 2 umgeben. Auf einer Oberseite des Gehäuseteils 2' ist ein ortsfester Rahmen 16 vorgesehen, in dem eine von einer Position in Höhe des Rahmens 16 aus mittels einer Lifteinrichtng 17 vertikal nach unten und vice versa verfahrbare Aufnahmeplatte 17 angeordnet ist. Der Rahmen ist mit nicht näher dargestellten Mitteln zur im Wesentlichen luftdichten Befestigung der Haube 13 eines SMIF-Behälters versehen, während die Aufnahmeplatte 18 ebenfalls nicht gezeigte Mittel zur Fixierung der Bodenplatte 12 des SMIF-Behälters 8 aufweist. Zudem kann mittels eines in der Aufnahmeplatte 18 angeordneten Mechanismus die Haube 13 von der Bodenplatte 12 gelöst und die beiden Elemente am Rahmen 16 bzw. der Aufnahmeplatte 18 befestigt werden. Damit kann das auf der Bodenplatte 12 stehende Magazin 11 eines SMIF-Behälters 8 aus diesem automatisiert entnommen werden, indem die Aufnahmeplatte 18 vertikal nach unten verfährt. Die in dem Magazin 11 angeordneten Reticles 9 werden somit in das Gehäuse 2 der Vorrichtung hin zu einer Be- und Entladeposition eingefahren. Hierbei wird das Magazin 11 an einer Scann-Einrichtung 19, beispielsweise einer CCD-Kamera und/oder einem Lichtschrankensensor, vorbeigeführt, welche feststellt, in welchem Fach ein Reticle 9 angeordnet ist. Gegebenenfalls kann mit der Scann-Einrichtung 19 auch ein auf jedem Reticle angeordnetes Identifikationsmittel, beispielsweise ein Bar-Code, gelesen werden.

An der gleichen Seite des Gehäuses 2 wie die SMIF-Station 7 und oberhalb von dieser ist als weiterer Bestandteil der Ein-/Ausgabeeinrichtung 3 eine Kassetten-Station 20 vorgesehen, mit der einzelne, in nicht dargestellten handelsüblichen, Kassetten angeordnete Reticles in und aus dem Gehäuse 2 geschleust werden können. Derartige Kassetten Stationen sind für sich genommen vielfach vorbekannt.

In Bezug auf eine vertikale Richtung ist zwischen der SMIF-Station und der Kassetten-Station 20 oberhalb einer zentralen elektrischen Versorgungseinheit 21 der erfindungsgemässen Vorrichtung 1, die mit einem eigenen Gehäuse versehene Detektionseinrichtung 6 vorgesehen, deren prinzipieller Aufbau in Fig. 3 näher gezeigt ist. Auf einem nicht näher dargestellten, in einer horizontalen X-Y Ebene verfahrbaren, Schlitten ist ein Reticle 9 zwischen zwei Armen 22, 23 eines Trägers angeordnet. Das Reticle weist mit seiner Glasseite 26 nach oben und mit seiner Pellicle-Seite 27 nach unten. An jedem Arm 22, 23 ist eine hochauflösende CCD-Zeilenkamera 28, 29 angebracht.

Das Reticle 9 befindet sich ausserdem im Strahlengang von zwei Laserstrahlen 30, 31, die so ausgerichtet sind, dass der eine Laserstrahl auf die Glasseite 26 und der andere Laserstrahl auf die Pellicle-Seite 27 des Reticles 9 trifft. Beide Laserstrahlen 30, 31 verlaufen mit nur einem geringen Neigungswinkel, und damit nahezu parallel, zu und unmittelbar über den ihnen zugeordneten Flächen. Auf den Flächen 26, 27 sitzende Schmutzpartikel 32, 33 befinden sich somit im Strahlengang der Laserstrahlen und lenken die Laserstrahlen 30, 31 ab. Die jeweilige CCD-Kamera 28, 29 erfasst das abgelenkte Licht 36 und kann - sofern dies von Interesse ist - in Abhängigkeit von dem gemessenen Licht die Grösse der Schmutzpartikel 32, 33 und deren Position auf dem Reticle 9 feststellen.

Fig. 1 zeigt, dass die Reinigungseinrichtung 5 oberhalb der Detektionseinrichtung 6 angeordnet und ebenfalls mit einem eigenen Gehäuse versehen ist. Die Reinigungseinrichtung 5 weist einen von aussen durch das Gehäuse 2 der Vorrichtung 1 führenden Anschluss 38 für unter Überdruck stehendes Gas, beispielsweise reiner Stickstoff, einer Gaszuführeinrichtung 39 auf. Der Anschluss führt in zwei Zuführrohre 40, 41, die an eine Reinigungskammer 42 angeschlossen sind. Die Reinigungskammer 42 ist ausserdem in einer nicht näher dargestellten Weise an ein Absaugmittel anschliessbar. Zudem ist die Reinigungseinrichtung 5 mit einem entlang einer X-Achse (d.h. horizontal in der Zeichenebene von Fig. 1) verfahrbaren Schlitten 43 versehen. Letzterer weist als Träger für Reticles einen Greifer 47 auf, mit dem ein horizontal ausgerichtetes Reticle 9 an einem seiner Enden gegriffen werden kann.

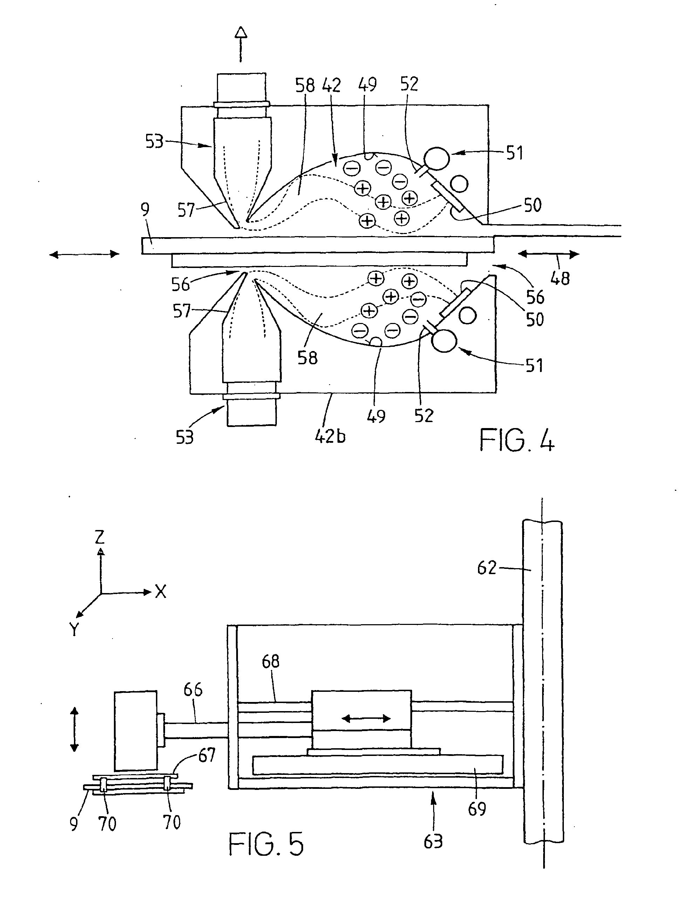

Wie Fig. 4 entnommen werden kann, ist die Reinigungskammer 42 der Reinigungseinrichtung 5 bezüglich einer im Wesentlichen horizontal verlaufenden X-Y-Ebene, in der auch das Reticle gemäss dem Doppelpfeil 48 bewegt wird, symmetrisch ausgebildet. Die Reinigungskammer 42 setzt sich somit aus zwei spiegelbildlich identischen oberen und unteren Hälften 42a, 42b zusammen, die jeweils eine in etwa konkav gekrümmte Kammerwand 49 aufweisen. Im Bereich eines Endes jeder Kammerwand 49 mündet eine Düse 50 der Gaszuführeinrichtung 5 in die Reinigungskammer 42 hinein. Neben jeder Düse 50 ist jeweils ein Ionisationsmittel 51 angeordnet, deren Elektroden 52 in die Kammer hineinragen. Die Elektroden 52 sind mit über eine gesamte Breite der Kammer reichende Emitter aus Titan besetzt, welche positive und negative Ionen in die Kammer abgeben. Die Ionen werden durch einen nicht näher dargestellten, an die Elektroden 52 angeschlossenen, Generator erzeugt.

Am anderen Ende der Kammer 42 ist in beiden Kammerhälften 42a, 42b jeweils eine Absaugeinrichtung 53 angeordnet, die in einer nicht näher dargestellten Weise an das Absaugmittel zur Erzeugung eines Unterdrucks angeschlossen ist. Zwischen den beiden Kammerhälften 42a, 42b ist an deren vorderen und hinteren Enden jeweils ein Spalt 56 ausgebildet, durch den ein Reticle 9 durch die Kammer 42 hindurchgeführt werden kann. Sowohl eine Breite des Spaltes 56 (Dimension orthogonal zur Zeichenebene von Fig. 4) als auch eine Höhe des Spaltes 56 (vertikale Richtung in Fig. 4, d.h. parallel zur Dicke des Reticles 9) sind nur unwesentlich grösser als ein Reticle 9 selbst. Ein Diffusor 57 jeder Absaugeinrichtung 53 befindet sich an der engsten Stelle des Spaltes 56, an der somit der Spalt 56 den geringsten Abstand zum Reticle aufweist. Eine Höhe des Spaltes könnte beispielsweise höchstens die Dicke des Reticles 9 plus maximal 2 mm, vorzugsweise plus maximal 0,5 mm bis 1 mm, betragen.

Mit Hilfe des Schlittens 43 und dessen Greifer 47 (Fig. 1) ist das jeweilige Reticle 9 durch die Kammer 42 hindurchführbar, so dass die aus den Düsen 50 austretenden Gasströme 58 auf jede Stelle der Ober- und Unterseite des Reticles ge-richtet werden können (Fig. 4). Die Gasströme 58 können jeweils unter einem Einfallswinkel von ca. 30° bis 60°, vorzugsweise von ca. 45°, auf die jeweilige Reticle-Fläche auftreffen. Die beiden Gasströme 58 werden von der Ober- bzw. Unterseite des Reticles unter einem Ausfallswinkel reflektiert, der im Wesentlichen dem Einfallswinkel entspricht. Es ist hierbei bevorzugt, wenn eine Strömungskomponente des austretenden Gases, die parallel zum Reticle 9 verläuft, der Bewegungsrichtung des Reticles 9 in der Kammer 42 während des Reinigungsprozesses entgegengesetzt ist. Verschmutzun-gen, insbesondere Partikel, die auf der Ober- oder Unterseite der Flächen abgelagert sind, werden durch den jeweiligen Gasstrom 58 abgelöst und mitgerissen.

Um zu vermeiden, dass sich die im Gasstrom 58 bzw. der Reinigungskammer befindlichen Partikel statisch aufladen und am Reticle 9 oder der Reinigungseinrichtung ablagern, wird mit dem Ionisationsmittel eine aktive Ionisation vorgenommen. Darunter ist zu verstehen, dass durch Erzeugung von positiven und negativen Ionen eine Neutralisation von statisch aufgeladenen Partikeln stattfindet.

Die Gasströme 58 bewegen sich im Folgenden in etwa wellenförmig in Richtung auf die Diffusoren 57 der Absaugeinrichtung und den Spalt 56 zu. Hierzu trägt sowohl die kinetische Energie der Gasströme 58 als auch der von den Absaugeinrichtungen erzeugte Unterdruck bei. Das Gas wird nun durch die Diffusoren 57 hindurch aus der Kammer abgesaugt.

Eine weitere Funktionseinheit der in Fig. 1 gezeigten erfindungsgemässen Vorrichtung kann eine Lagereinrichtung für eine Vielzahl von Reticles 9 sein. Eine solche Lagereinrichtung kann in Reihen und Spalten angeordnete Fächer zur Aufnahme und Zwischenlagerung von Reticles enthalten. Die Aufnahmen können im Wesentlichen Schlitze sein, in denen die Reticles eingeschoben werden. In der Darstellung von Fig. 1 können sich die Aufnahmen vor und hinter der Z-Achse befinden.

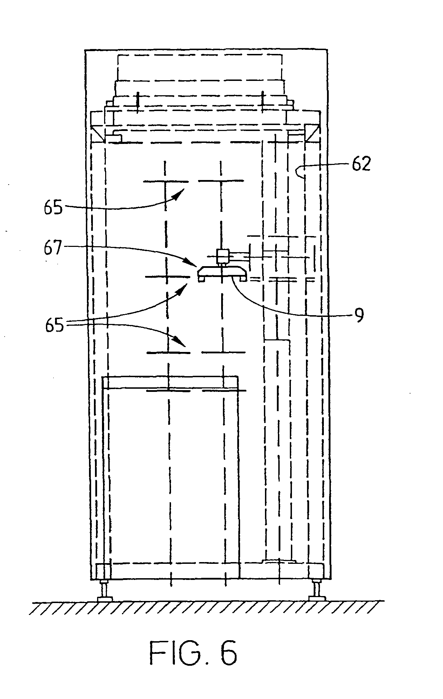

Wie Fig. 1 zu entnehmen ist, ist die Handhabungseinrichtung 4 der Vorrichtung 1 zwischen der SMIF-Station 7 und der Kassetten-Station 20 einerseits und Detektionseinrichtung 6 und der Reinigungseinrichtung 5 andererseits angeordnet. Die Handhabungseinrichtung 4 weist eine vertikal ausgerichtete lineare Z-Achse 62 auf, an der ein in Fig. 1 nur angedeuteter, in Z-Richtung verfahrbarer Schlitten 63 angeordnet ist. Der Schlitten ist in Fig. 5 und 6 näher dargestellt. Mit letzterem können Reticles an jeweils vor den einzelnen Funktionseinheiten fest installierten Übergabestellen 65 übergeben bzw. von den Übergabestellen 65 aufgenommen werden.

Der Schlitten 63 ist in Fig. 5 näher dargestellt. Er weist einen Tragarm 66 auf, an dem ein pneumatisch angetriebener Greifer 67 zur Handhabung einzelner Reticles 9 angebracht ist. Der Tragarm 67 ist zudem um zumindest 180° um die Z-Achse schwenkbar, so dass der Greifer 67 an alle Funktionseinheiten der erfindungsgemässen Vorrichtung Reticles übergeben bzw. aus ihnen entnehmen kann. Der Tragarm 66 ist ausserdem entlang seiner Längsachse in X-Richtung verschiebbar. Hierzu ist er mittels nicht dargestellten Kugelbuchsen auf einer Führungswelle 68 gelagert und wird zur Ausführung dieser Bewegung von einem pneumatischen Zylinder 69 angetrieben. Der Greifer 67 kann somit in unterschiedlichen Abständen zur Z-Achse angeordnet werden. Der Greifer 67 weist jeweils zwei paarweise angeordnete Klemmfinger 70 auf, zwischen denen jeweils ein Reticle 9 an Seitenflächen gegriffen werden kann. Mit der Handhabungseinrichtung 4 werden somit die Reticles zwischen den einzelnen Funktionseinheiten transportiert und an diese übergeben.

Schliesslich ist gemäss Fig. 1 oberhalb der Z-Achse 62 eine Einrichtung 71 zur Aufbereitung der im Gehäuse von oben nach unten strömenden Reinluft sowie zur Erzeugung der Strömungsrichtung der Reinluft vorgesehen. Die Luft kann durch im Boden des Gehäuses 2 vorhandene (nicht dargestellte) Schlitze austreten. Derartige Aufbereitungseinrichtungen 71 sind für sich genommen vielfach vorbekannt und dienen vor allem dazu, eventuell im Gehäuse 2 vorhandene Partikel abzuführen, bevor sie sich ablagern können.

Die einzelnen Funktionseinheiten der erfindungsgemässen Vorrichtung werden von einer zentralen, zeichnerisch nicht dargestellten, Rechnereinheit gesteuert und koordiniert. Ein Funktionsablauf der Vorrichtung kann beispielsweise damit beginnen, dass ein Reticle in der Kassetten-Station 20 aus seiner Kassette entnommen, der Barcode des Reticles 9 gelesen und diese Information zur Identifikation des Reticles in einem Speicher der Rechnereinheit gespeichert wird. Danach wird das Reticle 9 von dem Greifer 67 an der Kassetten-Station 20 geholt, zur Detektionseinrichtung 6 überführt und an diese übergeben. Das Reticle wird in der Detektionseinrichtung 6 auf Verschmutzungen inspiziert. Anzahl, Grösse und Ort der Partikel auf der Glas- und der Pellicle-Seite werden gemessen und die Messwerte werden im Speicher als weitere Information zu dem jeweiligen Reticle 9 abgespeichert.

Ergibt sich aufgrund der Untersuchung, dass eine Reinigung erforderlich ist, so bringt der Greifer 67 das Reticle 9 von der Detektionseinrichtung 6 zur Reinigungseinrichtung 5, in der das Reticle in der vorbeschriebenen Weise gereinigt wird. Bevor das Reticle nun entweder in der Kassetten-Station wieder in eine Kassette eingelegt oder in ein Fach der Lagereinrichtung abgelegt wird, kann es optional nochmals zur Detektionseinrichtung 6 gebracht werden. Durch eine nochmalige Untersuchung des Reticles nach dem Reinigungsvorgang kann der Reinigungseffekt kontrolliert bzw. überprüft werden. Ein abwechselndes Reinigen und Überprüfen des Reticles kann so lange automatisch wiederholt werden, bis keine Verschmutzungen ab einer bestimmten Partikelgrösse mehr vorhanden sind. Ebenso ist es möglich, dass das Reticle vor einer ersten Überprüfung zuerst gereinigt und erst danach eine Inspektion in der Detektionseinrichtung durchgeführt wird. Entspricht das Reticle den vordefinierten Sauberkeitsanforderungen und soll es in der Lagereinrichtung zur Zwischenlagerung abgelegt werden, so wird es vom Greifer 67 vor eine von der Rechnereinheit vorgegebene Aufnahme gebracht und darin abgelegt. Sobald dieser Vorgang abgeschlossen ist, wird zu den abgespeicherten Informationen über das jeweilige Reticle auch eine Information zur Identifikation der jeweiligen Aufnahme hinzugefügt, damit das Reticle auf einfache Weise wieder aufgefunden werden kann. Soll zu einem späteren Zeitpunkt das Reticle ausgegeben werden, so kann dies über eine nicht dargestellte Eingabeeinrichtung das entsprechende Reticle angefordert werden, woraufhin der Greifer 67 zu der entsprechenden Aufnahme verfährt, das Reticle entnimmt, zur Ein-/Ausgabeeinrichtung bringt und an diese übergibt, woraufhin das Reticle ausgegegeben wird. Hierbei passiert das Reticle wieder eine der Scann-Einrichtungen, welche den Bar-Code des Reticles lesen und dieses in der Rechnereinheit als ausgegeben ausbuchen.

Bezüglich der Anordnung der einzelnen Funktionseinheiten in der erfindungsgemässen Vorrichtung sind selbstverständlich eine Vielzahl von Variationen möglich. Ebenso können einzelne der in Fig. 1 gezeigten Funktionseinheiten auch weggelassen werden, falls deren Funktionen nicht benötigt werden. So kann beispielsweise auch vorgesehen sein, dass die Vorrichtung nur eine oder zwei Übergabestationen (SMIF-Station 7 und/oder Kassetten-Station 20) einer Ein-/Ausgabeeinrichtung und eine Detektionseinrichtung 6 in dem Gehäuse aufweist. Optional können auch in diesem Gehäuse noch eine Lagereinrichtung angeordnet sein. Die Reinigung der Reticles kann in diesem Fall ausserhalb des Gehäuses in einer gesonderten Reinigungseinrichtung erfolgen.

In einer Weiterbildung des zuletzt genannten Ausführungsbeispiels kann zu der Ein-/Ausgabestation und der Detektionseinrichtung noch zusätzlich eine Reinigungseinrichtung hinzukommen. Bis auf die Lagereinrichtung kann dieses Ausführungsbeispiel der in Fig. 1 dargestellten Vorrichtung entsprechen. Schliesslich kann es auch vorteilhaft sein, wenn bei der erfindungsgemässen Vorrichtung sämtliche Funktionseinheiten im Wesentlichen auf der gleichen Höhe angeordnet sind. Hierzu kann die Vorrichtung im Querschnitt beispielsweise kreisrund sein und bis auf die Handhabungseinrichtung die Funktionseinheiten am Umfang des Querschnittes im Wesentlichen gleichmässig verteilt sein. Die Handhabungseinrichtung kann in der Mitte angeordnet sein, so dass sie zu allen Funktionseinheiten Zugang hat. In einem anderen Ausführungsbeispiel kann der Querschnitt rechteckförmig und die Funktionseinheiten an den beiden Längsseiten gleichmässig verteilt sein.

## Patentansprüche

1. Reinigungsvorrichtung für die Halbleiterbauelementeproduktion, die mit zwei Zuführeinrichtungen versehen ist, mit denen jeweils ein fluides Medium über jeweils eine Oberfläche eines zu reinigenden Objekts, insbesondere eines Halbleiterproduktionsmittels (9), führbar ist, so dass sich unterschiedliche Seiten des Objektes (9) gleichzeitig reinigen lassen, wobei in eine Reinigungskammer (42) zumindest zwei Gaszuführeinrichtungen (5) zur Einführung eines unter Überdruck stehenden Reinigungsgases münden, die Gaszuführeinrichtungen (5) jeweils ein Mittel (50) zur Richtung eines Gasstromes auf eine Oberfläche des zu reinigenden Objekts (9) aufweisen, aus der Reinigungskammer (42) zumindest zwei Absaugmittel (53) herausführen, mit der in die Reinigungskammer (42) hineingeleitetes Gas abführbar ist, und ein Träger zur Halterung des Objektes (9) in der Reinigungskammer (42) vorhanden ist, wobei
- das Objekt (9) in die Reinigungskammer (42) durch zumindest einen Spalt (56) in der Reinigungskammer (42) einführbar ist,
- in der Reinigungskammer (42) befindliches Gas und Partikel mit zumindest zwei Ionisationsmittel (51) ionisierbar ist, wobei sich jeweils ein Ionisationsmittel (51) zwischen jeweils einem Richtungsmittel (50) und einer Absaugeinrichtung (53) befindet.

2. Reinigungsvorrichtung nach Anspruch 1, **dadurch gekennzeichnet**, das der Spalt (56) nicht mehr als 2 mm grösser ist als eine Dicke des Objektes.

3. Reinigungsvorrichtung nach einem der Ansprüche 1 oder 2, **dadurch gekennzeichnet, dass** die Absaugeinrichtung (53) jeweils in der Nähe des Spaltes (56) ausgebildet ist.

4. Reinigungsvorrichtung nach einem der Ansprüche 1 oder 2, **dadurch gekennzeichnet, dass** die Absaugeinrichtung (53) jeweils mit einem Kanal ausgebildet ist, der durch den Spalt (56) begrenzt wird.

5. Reinigungsvorrichtung nach Anspruch 1 bis 4, **dadurch gekennzeichnet, dass** der Träger einen verfahrbaren Greifer (43, 47) aufweist.

6. Reinigungsvorrichtung nach Anspruch 5, **dadurch gekennzeichnet, dass** das zu reinigende Objekt (9) mittels des verfahrbaren Greifers (43, 47) in die Reinigungskammer (42) ein- und ausführbar ist.

7. Reinigungsvorrichtung nach einem oder mehreren der vorhergehenden Ansprüche, **dadurch gekennzeichnet, dass** die Reinigungskammer (42) in Bezug auf die Ebene, in der das zu reinigende Objekt (9) durch den Spalt (56) in die Kammer (42) einführbar ist, im Wesentlichen symmetrisch aufgebaut ist.

8. Reinigungsvorrichtung nach einem oder mehreren der vorhergehenden Ansprüche, **dadurch gekennzeichnet, dass** die Absaugeinrichtungen (53) in Bezug auf die Richtungsmittel (50) im Wesentlichen in der Strömungsrichtung (58) des Gases angeordnet ist.

9. Reinigungsvorrichtung nach einem der vorhergehenden Ansprüche, **gekennzeichnet durch** eine Detektionseinrichtung (6) zur Dektierung von Verschmutzungen auf Objekten (9).

10. Verwendung einer Reinigungsvorrichtung gemäss einem oder mehreren der vorhergehenden Ansprüche 1 bis 9, **dadurch gekennzeichnet, dass** mit ihr Zwischenprodukte von Halbleiterbauelementen (9), beidseitig gleichzeitig gereinigt werden.

11. Vorrichtung zur Lagerung von Objekten (9) aus der Halbleiterproduktion, insbesondere von Reticles, umfassend ein allseitig geschlossenes Gehäuse, in dem eine Lagereinrichtung mit Lagerplätzen zur Aufnahme und Lagerung der Objekte (9) vorgesehen ist, eine Handhabungseinrichtung zur Handhabung der Objekte innerhalb des Gehäuses, sowie eine Aus-/Eingabestation für die Objekte, um diese aus der Lagereinrichtung heraus bzw. in sie hineinzuführen, **dadurch gekennzeichnet, dass** in dem Gehäuse eine Reinigungseinrichtung nach einem der Ansprüche 1 bis 9 zur Reinigung der Objekte von auf ihnen abgelagerten Partikeln vorhanden ist.

12. Vorrichtung nach Anspruch 11, **gekennzeichnet durch** eine in dem Gehäuse angeordnete Detektionseinrichtung (6) zur Detektion von auf Halbleiterproduktionsmitteln vorhandenen Verschmutzungen.

13. Vorrichtung nach Anspruch 12, **dadurch gekennzeichnet, dass** die Detektionseinrichtung zumindest ein Mittel (30, 31) zur Lichtemission aufweist, mit dem zumindest ein Lichtstrahl, insbesondere ein Laserstrahl, auf zumindest eine Oberfläche des Objekts (9) leitbar ist, zumindest ein Empfängermittel (28, 29) vorhanden ist, mit dem das von dem Objekt (9) reflektierte Licht empfangen wird und in Form eines Messsignals einer Auswerteeinheit zugeführt wird, die aufgrund des Messignals bestimmt, ob das Objekt verschmutzt (32, 33) ist.

14. Verfahren zur Reinigung von Objekten (9) aus der Halbleiterproduktion, bei dem zur Entfernung von Verschmutzungen (32, 33) ein fluides Medium (58) über das Objekt (9) geleitet wird, **dadurch gekennzeichnet, dass** das Objekt in einer Reinigungskammer mit einer Reinigungsvorrichtung nach Anspruch 1 bis 9 angeordnet wird, in der ein gasförmiges Medium eingebracht und das über das Objekt geleitete Medium abgesaugt wird.

15. Verfahren nach Anspruch 14, **dadurch gekennzeichnet, dass** das Medium zumindest überwiegend Stickstoff enthält.

## Claims

1. Cleaning device for semiconductor element production provided with two supply devices with each of which a fluid medium can be conveyed over, in each case, one surface of an object to be cleaned, more particularly a semiconductor production means (9), so that different sides of the object (9) can be cleaned simultaneously, whereby at least two gas supply devices (5) for supplying a cleaning gas at overpressure open out into the cleaning chamber (42), the gas supply devices (5) each having a means (50) for directing a gas flow onto a surface of the object (9) to be cleaned, emerging from the cleaning chamber (42) there are at least two extraction means (53) with the gas fed into the cleaning chamber (42) can be removed, and a carrier to hold the object (9) is present in the cleaning chamber (42), whereby
- the object (9) can be introduced into the cleaning chamber (42) through at least one gap (56) in the cleaning chamber (42),
- gas and particles present in the cleaning chamber (42) can be ionised with at least two ionisation means (51), whereby one ionisation means (51) is located in each case between a directing means (50) and an extraction device (53).

2. Cleaning means in accordance with claim 1, **characterised in that** the gap (56) is not more than 2 mm larger than the thickness of the object.

3. Cleaning device in accordance with any one of claims 1 or 2, **characterised in that** each of the extraction devices (53) is arranged close to the gap (56).

4. Cleaning device in accordance with any one of claims 1 or 2, **characterised in that** each of the extraction devices (53) is designed with a channel which is delimited by the gap (56).

5. Cleaning device in accordance with claims 1 to 4, **characterised in that** the carrier has a movable grip (43, 47)

6. Cleaning device in accordance with claim 5, **characterised in that** the object (9) to be cleaned can be introduced into and removed from the cleaning chamber (42) by way of the movable grip (43, 47).

7. Cleaning device in accordance with one or more of the preceding claims, **characterised in that** the cleaning chamber (42) is essentially symmetrically arranged in relation to the plane in which the object (9) to be cleaned can be introduced through the gap (56) into the chamber (42).

8. Cleaning device in accordance with one or more of the preceding claims, **characterised in that** in relation to the directing means (50), the extraction devices (53) are essentially arranged in the direction of flow (58) of the gas.

9. Cleaning device in accordance with any one of the preceding claims, **characterised by** a detection device (6) for detecting contamination on objects (9).

10. Use of a cleaning device in accordance with one or more of the preceding claims 1 to 9, **characterised in that** with it intermediate products of semiconductor elements (9) can be cleaned on both sides simultaneously.

11. Device for storing semiconductor production objects (9), more particularly reticles, comprising a casing closed on all sides in which a storage device with storage places for accommodating and storing the objects (9) is provided, a handling device for handling the objects inside the casing, well as an input/output station for the objects for removing or introducing them from and into the storage device, **characterised in that** provided in the casing is a cleaning device in accordance with any one of claims 1 to 9 for cleaning the objects of particles deposited on them.

12. Device in accordance with claim 11, **characterised by** a detection device (6) arranged in the casing for detecting contamination present on semiconductor production means.

13. Device in accordance with claim 12, **characterised in that** the detection means has at least one means (30, 31) for emitting light, with which at least one light beam, more particularly a laser beam, can be directed onto at least one surface of the object (9), at least one receiver means (28, 29) is present with which the light reflected from the object (9) is received and supplied in the form of a measuring signal to an evaluation unit, which on the basis of the measuring signal determines whether the object is contaminated (32, 33).

14. Method of cleaning semiconductor production objects (9) in which to remove contamination (32, 33) a fluid medium (58) is passed over the object (9), **characterised in that** the object is arranged in a cleaning chamber with a cleaning device in accordance with claims 1 to 9, into which a gaseous medium is introduced and the medium passed over the object is extracted,

15. Method in accordance with claim 14, **characterised in that** the medium at least predominantly contains nitrogen.

## Revendications

1. Dispositif de nettoyage pour la production de composants à semi-conducteurs, qui est doté de deux dispositifs d'arrivée, avec lesquels respectivement un agent fluide peut être guidé par respectivement une surface d'un objet à nettoyer, en particulier d'un moyen de production de semi-conducteurs (9), de sorte que différents côtés de l'objet (9) peuvent être nettoyés en même temps, au moins deux dispositifs d'arrivée de gaz (5) débouchant dans une chambre de nettoyage (42) pour l'introduction d'un gaz de nettoyage mis sur pression, les dispositifs d'arrivée de gaz (5) présentant chacun un moyen (50) pour diriger un flux de gaz sur une surface de l'objet (9) à nettoyer, guidant au moins deux moyens d'aspiration (53) à la sortie de la chambre de nettoyage (42), avec lequel du gaz introduit à l'intérieur de la chambre de nettoyage (42) peut être évacué, et un support pour la fixation de l'objet (9) étant présent dans la chambre de nettoyage (42),
- l'objet (9) pouvant être introduit dans la chambre de nettoyage (42) par au moins une fente (56) dans la chambre de nettoyage (42),
- du gaz se trouvant dans la chambre de nettoyage (42) et des particules pouvant être ionisées avec au moins deux moyens d'ionisation (51), à chaque fois un moyen d'ionisation (51) se trouvant entre respectivement un moyen de direction (50) et un dispositif d'aspiration (53).

2. Dispositif de nettoyage selon la revendication 1, **caractérisé en ce que** la fente (56) n'est pas plus de 2 mm plus grande qu'une épaisseur de l'objet.

3. Dispositif de nettoyage selon l'une quelconque des revendications 1 ou 2, **caractérisé en ce que** le dispositif d'aspiration (53) est réalisé respectivement à proximité de la fente (56).

4. Dispositif de nettoyage selon l'une quelconque des revendications 1 ou 2, **caractérisé en ce que** le dispositif d'aspiration (53) est réalisé respectivement avec un canal qui est délimité par la fente (56).

5. Dispositif de nettoyage selon les revendications 1 à 4, **caractérisé en ce que** le support présente une griffe (43, 47) déplaçable.

6. Dispositif de nettoyage selon la revendication 5, **caractérisé en ce que** l'objet (9) à nettoyer peut être introduit dans la chambre de nettoyage (42) au moyen de la griffe (43, 47) déplaçable et peut être sorti.

7. Dispositif de nettoyage selon l'une quelconque ou plusieurs des revendications précédentes, **caractérisé en ce que** la chambre de nettoyage (42) est conçue de façon sensiblement symétrique par rapport au plan dans lequel l'objet (9) à nettoyer peut être introduit par la fente (56) dans la chambre (42).

8. Dispositif de nettoyage selon l'une quelconque ou plusieurs des revendications précédentes, **caractérisé en ce que** le dispositif de nettoyage (53) est disposé par rapport aux moyens de direction (50) sensiblement dans le sens d'écoulement (58) du gaz.

9. Dispositif de nettoyage selon l'une quelconque des revendications précédentes, **caractérisé par** un dispositif de détection (6) pour la détection d'encrassements sur des objets (9).

10. Utilisation d'un dispositif de nettoyage selon l'une quelconque ou plusieurs des revendications précédentes 1 à 9, **caractérisé en ce que** des produits intermédiaires de composants à semi-conducteurs (9) sont nettoyés en même temps des deux côtés avec ce dispositif.

11. Dispositif pour le stockage d'objet (9) provenant de la production de semi-conducteurs, en particulier de réticules, comprenant un boîtier fermé de tous côtés, dans lequel est prévu un dispositif de stockage avec des emplacements de stockage pour le logement et le stockage des objets (9), un dispositif de manipulation pour la manipulation des objets à l'intérieur du boîtier ainsi qu'une station d'entrée/sortie pour les objets, afin de les sortir du dispositif de stockage ou de les introduire dans celui-ci, **caractérisé en ce que** un dispositif de nettoyage selon l'une quelconque des revendications 1 à 9 est présent dans le boîtier pour débarrasser les objets des particules déposées sur ceci.

12. Dispositif selon la revendication 11, **caractérisé par** un dispositif de détection (6) disposé dans le boîtier pour la détection d'encrassements présents sur des moyens de production de semi-conducteurs.

13. Dispositif selon la revendication 12, **caractérisé en ce que** le dispositif de détection présente au moins un moyen (30, 31) pour l'émission de lumière, avec lequel au moins un faisceau de lumière, en particulier un faisceau laser, peut être guidé sur au moins une surface de l'objet (9), au moins un moyen récepteur (28, 29) étant présent, avec lequel la lumière réfléchie par l'objet (9) est reçue et est amenée sous la forme d'un signal de mesure à une unité d'analyse qui détermine sur la base du signal de mesure si l'objet est encrassé (32, 33).

14. Procédé pour nettoyer des objets (9) provenant de la production de semi-conducteurs, dans lequel, pour éliminer des encrassements (32, 33), un agent (58) fluide est guidé sur l'objet (9), **caractérisé en ce que** l'objet est disposé dans une chambre de nettoyage avec un dispositif de nettoyage selon les revendications 1 à 9, dans lequel un agent gazeux est introduit et l'agent guidé au-dessus de l'objet est aspiré.

15. Procédé selon la revendication 14, **caractérisé en ce que** l'agent contient au moins principalement de l'azote.
